Europäisches Patentamt

European Patent Office

Office européen des brevets

(11) Publication number: **0 353 055**
A1

## (12) EUROPEAN PATENT APPLICATION

(21) Application number: **89307617.4**

(22) Date of filing: **27.07.89**

(51) Int. Cl.⁵: **H 05 B 33/02**
H 05 B 7/08

(30) Priority: **27.07.88 US 225079**

(43) Date of publication of application:
**31.01.90 Bulletin 90/05**

(84) Designated Contracting States:
**AT BE CH DE ES FR GB GR IT LI LU NL SE**

(71) Applicant: **CSL LIGHTING, INC. (an Illinois corporation)**
**11150 Olympic Boulevard**
**Los Angeles California 90064 (US)**

(72) Inventor: **Conti, Mario W.**
**7044 Estrella Del Mar Road Carlsbad**
**California 92009 (San Diego County) (US)**

(74) Representative: **Maggs, Michael Norman et al**
**Kilburn & Strode 30 John Street**
**GB-London WC1N 2DD (GB)**

(54) **Flexible conductive strip.**

(57) A strip lighting assembly includes an insulated pair of copper foil strips to which one or more sockets have been connected. The assembly is produced by placing foil strips on one side of a wide insulating film, placing strips of the same insulating film material over the foil so as at least partially to cover it, installing lamp sockets from the opposite side through the film and exposed foil and finally, overlapping the film edges to cover the exposed foil. The invention extends both to the product and to a method of manufacture.

Fig.2.

## Description

## FLEXIBLE CONDUCTIVE STRIP

The present invention is concerned with flexible conductive strips and more particularly, conductive lighting strips which can be used for example for display cases, shelves and other areas where an array of lighting elements needs to follow irregular contours or borders.

Typically, display case shelving has been illuminated by affixing a lighting fixture such as a fluorescent bulb or a line of incandescent bulbs within a reflective shield to the front underside of a top shelf. Such lighting sources, however, do not provide optimum illumination. In fact, they tend to distort colours as compared with their appearance in natural sunlight, and, when incandescent lamps are used, they tend to be wasteful of power. Because colour is an important feature of most items placed in a display case, it is preferable that more natural illumination be provided.

Moreover, most available lighting fixtures are relatively bulky or are of the fluorescent type which do not provide the proper lighting for the display of most objects. A small, flexible, low voltage illumination strip would be most desirable for such display case applications.

Strip lighting which follows the contours of an architectural feature, or which outlines and illuminates special features of a structure, is typically created using conventional wiring which includes a plurality of lamp sockets spaced at desired intervals. "Christmas tree" lighting is an example of this variety. Such strip lighting is typically wired in series and if one bulb fails the whole strip fails through an open circuit. A painstaking bulb-by bulb inspection is then required to find the failed unit or units. Parallel wiring, on the other hand, would be preferable, since burnt out bulbs can be quickly located and replaced. However, heavier gauge wiring is necessary because the current that must be supplied in a parallel circuit is equal to the product of the current in one lamp times the number of lamps.

The strip lighting employed in the prior art is generally unattractive and not easily fastened in place. Further, conventional, small gauge wiring necessary for an inconspicuous installation can have relatively high resistivity over long runs which adversely affects the brightness that is available. What is required, therefore, is strip lighting that can be both flexible and of low resistivity. Further, it should lend itself to the parallel wiring of the component lighting elements with the required high conductivity and whch can be easily concealed or obscured from view.

An object of the present invention is to provide low profile strip lighting having flexibility and low resistivity combined with an excellent light spectrum.

In general the present invention is embodied in an improved display lighting apparatus comprised of an electrically conductive strip that is adapted to be easily fastened to any surface and has a pair of conductors. Each conductor of the strip has substantial current capacity and is adapted to be connected to a corresponding power terminal of a power source, which may be the output terminals of a low voltage power supply transformer.

The electrically conductive strip includes two generally parallel lengths of conductive foil covered by an insulative film. Lamp socket members are held by a spacer to the strip and are electrically connected across the two foil strips. Light fixtures or lamps may then be plugged into these sockets to provide a strip of illumination, particularly effective with display case shelving.

By adapting the flexible strip to receive other types of socket members, the present invention can be adapted to provide a power source for electrical accessories other than lights.

Further advantages and features of the present invention will be more fully apparent from the ensuing detailed description of three exemplary embodiments thereof, in conjunction with the accompanying drawings wherein like reference numerals refer to like parts throughout, and in which:

Figure 1 is a bottom perspective view of a length of strip lighting with a lamp socket assembly attached thereto;

Figure 2 is an enlarged cross-sectional view taken along line 2-2 of Figure 1, in the direction of the appended arrows with a light bulb shown in dotted lines;

Figure 3 is a cross-sectional view of a length of unfolded strip lighting showing the placement of conductive material upon the laminar surface in a first embodiment;

Figure 4 is a cross-sectional view of a length of unfolded strip lighting showing the placement of insulative material over the conductive material;

Figure 5 is a cross-sectional view of the strip lighting of the present invention in an unfolded configuration having a socket thereon;

Figure 6 is a view of the strip of Figure 5 showing a first fold; and

Figure 7 is a view of the strip of Figure 6 showing a second fold.

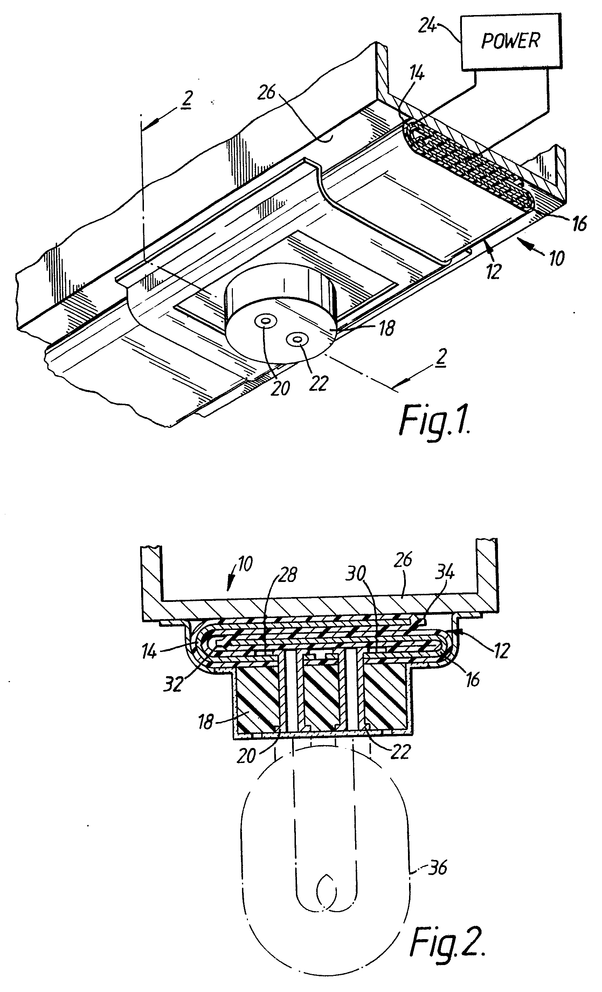

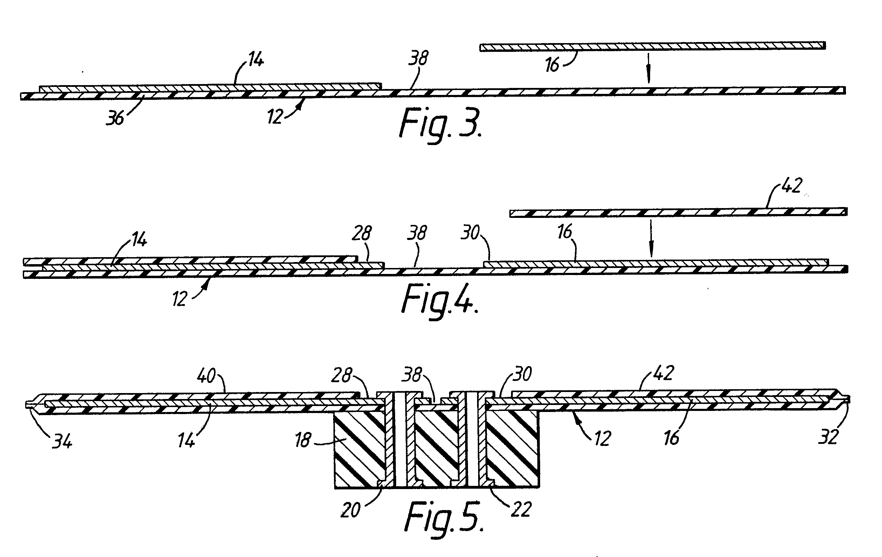

The details of the construction of strip lighting 10 are shown in Figures 1 and 2. Figure 1 shows the fully insulated strip lighting assembly 10 mounted for illumination purposes. Figure 2 shows an enlarged cross-sectional view of the fully assembled strip lighting assembly. From Figure 1, it can be seen that a typical strip 10 includes an insulating laminate 12, which surrounds a conductive pair (foil strips) 14, 16 to which a socket element 18 has been attached. A pair of pin receptacles 20, 22 are in electrical contact with the conductor pair 14, 16 and are adapted to connect to a source of power 24. As seen, the strip 10 is mounted on a substrate 26, which may be a structural element whose contours can be followed.

In the cross-sectional view of Figure 2, the strip 10 is shown enlarged so that the various components and their interrelationships can be visualized. In Figure 2, the length of laminate strip 12 has already been folded over as will be described below. It is at the exposed portions 28 and 30 of the two foil strips 14 and 16 that the electric contact is made with pin receptacle sockets 20 and 22. Socket 20 is soldered, or otherwise electrically connected, to the exposed strip 28 and socket 22 is electrically connected to exposed strip 30. After electrically connecting the exposed strip 28 of foil portion 14 and exposed strip 30 of foil portion 16 to the sockets 20 and 22, respectively, the laminate strip 12 is then folded over. Firstly, edge 32 is folded over the base of the sockets 20 and 22 and then, edge 34 is folded over edge 32 also over both of the sockets.

This provides the fully insulated assembly, as shown in Figure 1, except for the two exposed sockets 20, 22 into which a bulb, such as bulb 36, may be inserted. Although an exposed bulb 36 is shown in Figure 2, other lighting fixtures may be alternatively used. For instance, a bulb and reflector assembly, (not shown) might be used. In this manner, a reflector may be aimed so that light emitted by the bulb is directed toward a desired object. Thus, the same strip may contain exposed bulbs, such as bulb 36, or bulb and reflector assemblies.

Thus, an exceptionally flexible strip lighting assembly can easily be provided with illumination appropriate to articles on display shelves. It is not necessary that a bulb be plugged in each of the sockets in the event less light is desirable. The lengths of strip lighting 10 may be mounted under the front edge of the shelves of a display case. Alternatively, it may be provided under the side edges, the back dge or along the middle of the underside of any of the shelves. Thus, the concept is, of course, not limited to lighting along the front edge of a display case. Nor is the concept limited to display case lighting. The strip lighting assembly can be used wherever low voltage natural illumination is sought. It can be used to illuminate foot paths or along theatre aisles at floor level. It can also be used to display items in showcases, china cabinets and breakfronts.

The flexible strip lighting assembly can be folded in such a fashion as to provide variant spacing between the lamps. By folding and overlapping the strip, the distances between lamps can be changed according to various lighting and architectural requirements.

The flexible strip assembly can also be easily adapted to provide a power source for various electrical accessories other than lights. Other types of socket members which are adapted to provide power to electrical accessories can be affixed to the flexible strip, providing a flexible, parallel power source. Desirably, the strip is provided with a power plug.

The present invention also includes a method of fabricating the flexible electrically conductive strip means, as shown in Figures 3 to 7. As shown in Figure 3, two conductive strips 14 and 16 are placed on a strip of insulating material 36 in generally parallel relationship to the longitudinal axis. Strips 14 and 16 are aligned on insulating material 36 in a parallel fashion but are separated from one another by a gap 38 of about one-sixteenth of an inch (1.6 mm).

As shown in Figure 4, a first insulator strip 40 is then placed over the foil strip 14 and a second insulator strip 42 is placed over the foil strip 16. The first and second insulators 40 and 42 cover the foil strips 14 and 16 except for the two narrow, exposed portions 28 and 30.

As seen in Figure 5, the first and second insulator strips 40 and 42 are laminated to strip 12 at the ends 32 and 34. A socket 20 of the socket element 18 is soldered, or otherwise electrically connected, to the exposed conductive strip 28 and a socket 22 of socket element 18 is electrically connected to the exposed conductive strip 30. After the electrical connections are made, the laminated strip 12 is then folded over.

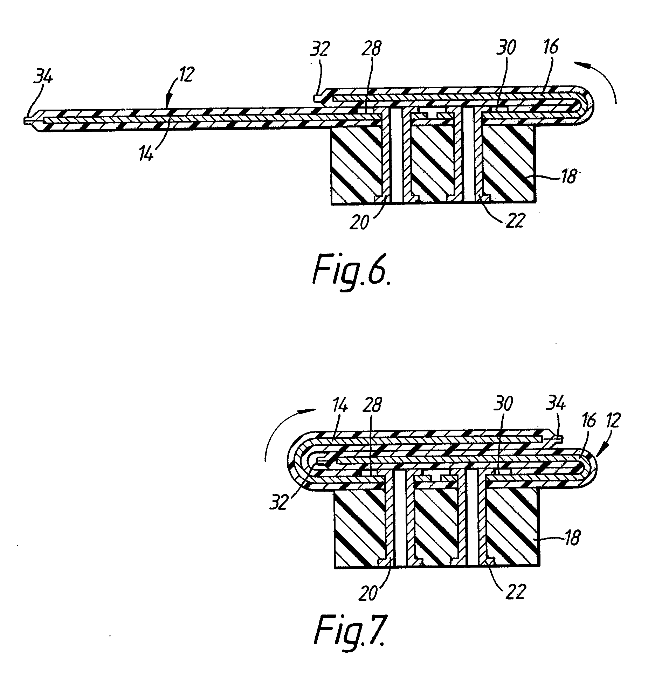

Turning next to Figure 6, the edge 32 is folded over the base of the sockets 20 and 22 covering the exposed portions of the conductive strips 28 and 30. Then, as seen in Figure 7, the edge 34 is folded over the edge 32 also covering both of the sockets 20 and 22 and the previously exposed portions 28 and 30. The resuhlting fully insulated assembly of Figure 7, also seen in Figure 2, shows the bulb 36 inserted into the two exposed sockets 20 and 22.

## Claims

1. A flexible electrically conductive strip (10) comprising first (16) and second (14) generally parallel conductive ribbons; an insulating substrate (12) secured to the lower surface of the ribbons; a separate insulating film (40, 42) secured to the upper surface of the ribbons; one side of the insulating film, the first ribbon and the insulating substrate being folded over lengthwise in a first fold, and the other side of the insulating material, the second ribbon and the insulating substrate being folded lengthwise in a second fold so as to overlap the first fold.

2. A strip as claimed in Claim 1 in which the respective lateral edges (34, 32) of the insulating substrate (12) and the insulating film (40, 42) are secured together.

3. A strip as claimed in Claim 1 or Claim 2 including at least one socket element (18) connected between the first and second ribbons (16, 14).

4. A strip as claimed in Claim 3 in which the socket element (18) is connected through the substrate (12).

5. A method of preparing a flexible electrically conductive strip (10) comprising: securing an insulating substrate (12) to the lower surface of first (16) and second (14) generally parallel conductive ribbons; securing a separate insulating film (40, 42) to the upper surface of the ribbons; folding one side of the insulating film, the first ribbon and the insulating substrate over lengthwise in a first fold; and folding the other side of the insulating material, the second ribbon and the insulating substrate lengthwise in a second fold so as to overlap the first fold.

6. A method of preparing a flexible electrically conductive strip as claimed in Claim 5 including the step of securing together the respective lateral edges (34, 32) of the insulating film (40, 42) and the insulating substrate (12).

7. A method of preparing a flexible electrically conductive strip as claimed in Claim 5 or Claim 6 including electrically connecting at least one socket element (18) to the ribbons (16, 14) prior to the step of effecting the first fold.

8. A method of preparing a flexible electrically conductive strip as claimed in Claim 7 in which the socket element (18) is connected to the ribbons (16, 14) through the insulating substrate (12).

9. A method of preparing a flexible electrically conductive strip as claimed in Claim 7 or Claim 8 including connecting a plurality of socket elements (18) along the length of the flexible strip (10) and then folding the flexible strip (10) transversely to its length to provide a chosen variable spacing between adjacent socket elements (18).

Fig.1.

Fig.2.

Fig.3.

Fig.4.

Fig.5.

Fig.6.

Fig.7.

| DOCUMENTS CONSIDERED TO BE RELEVANT | | | EP 89307617.4 |
|---|---|---|---|

| Category | Citation of document with indication, where appropriate, of relevant passages | Relevant to claim | CLASSIFICATION OF THE APPLICATION (Int. Cl.⁵) |
|---|---|---|---|
| A | <u>DE - A1 - 3 023 341</u><br>(DAIMLER-BENZ)<br>   * Totality *<br>   -- | 1,3 | H 05 B 33/02<br>H 05 B 7/08 |
| A | <u>DE - A - 1 938 419</u><br>(RUPPERT)<br>   * Page 4, lines 18-25;<br>   page 5; fig. 1-3 *<br>   -- | 1,5 | |
| A | <u>GB - A - 2 121 594</u><br>(FILOTEX)<br>   * Page 1, line 121 - page 2,<br>   line 81; fig. 1-6 *<br>   -- | 1,5 | |
| A | <u>DE - A1 - 2 548 218</u><br>(INTERNATIONAL VIBRATION<br>ENGINEERING)<br>   * Claims 1-9; fig. 4,6,7 *<br>   ---- | 1 | |
| | | | TECHNICAL FIELDS SEARCHED (Int. Cl.⁵) |
| | | | H 05 B 33/00<br>H 01 B 7/00<br>H 01 B 13/00<br>F 21 V 1/00 |

The present search report has been drawn up for all claims

| Place of search | Date of completion of the search | Examiner |
|---|---|---|
| VIENNA | 02-11-1989 | VAKIL |